# FASCICULE DE BREVET EUROPEEN

(11) **EP 0 801 419 B1**
(45) Date de publication et mention de la délivrance du brevet: **14.11.2007**
(21) Numéro de dépôt: 97400815.3
(22) Date de dépôt: 09.04.1997
(51) Int. Cl.: H01L 21/265, H01L 21/762

(54) **Procédé d'obtention d'un film mince de matériau semiconducteur comprenant notamment des composants électroniques**
Herstellungsverfahren von einem dünnen Halbleiterfilm, der elektronische Anordnungen enthält
Process of making a thin semiconductor film comprising electronic devices

(30) Priorité: 11.04.1996 FR 9604517
(43) Date de publication de la demande: 15.10.1997
(73) Titulaire: COMMISSARIAT A L'ENERGIE ATOMIQUE, 75015 Paris (FR)
(72) Inventeur: Aspar, Bernard, 38140 Rives (FR); Biasse, Béatrice, 38410 Uriage (FR); Bruel, Michel, 38113 Veurey (FR)
(74) Mandataire: Poulin, Gérard

(56) Documents cités:
- EP-A- 0 533 551
- EP-A- 0 660 140
- GAT A ET AL: "PHYSICAL AND ELECTRICAL PROPERTIES OF LASER-ANNEALED ION-IMPLANTED SILICON" 1 Mars 1978 , APPLIED PHYSICS LETTERS, VOL. 32, NR. 5, PAGE(S) 276 - 278 XP000608570 * page 276, colonne 1, alinéa 3 - colonne 2, alinéa 2 *

## Description

La présente invention concerne un prodédé d'obtention d'un film mince de matériau semiconducteur comprenant notamment des composants électroniques. Le film mince est obtenu par séparation d'une partie de faible épaisseur d'un substrat, dans laquelle on a élaboré par exemple un ou plusieurs composants électroniques et/ou des conducteurs électriques, d'avec le reste du substrat qui possède une épaisseur relativement plus importante. En fonction de l'application envisagée, l'invention permet également le transfert du film mince de son substrat initial vers un autre substrat ou support.

On cherche souvent, en microélectronique à réaliser des composants électroniques dans un film mince semiconducteur supporté par un support isolant ou séparé de son support par une couche électriquement isolante. On peut ainsi obtenir des structures dites Silicium Sur Isolant à partir desquelles on peut élaborer des composants électroniques. Pour obtenir ces structures, on peut utiliser :
- des méthodes d'hétéroépitaxie permettant, par croissance cristalline, de faire croître un cristal par exemple en silicium en film mince sur un substrat monocristallin d'une autre nature dont le paramètre de maille est voisin de celui du silicium, par exemple : substrat de saphir (Al₂0₃) ou de fluorure de calcium (CaF₂) ;
- le procédé dit "SIMOX" (nom couramment utilisé dans la littérature) qui utilise l'implantation ionique à forte dose d'oxygène dans un substrat de silicium pour créer dans le volume du silicium une couche d'oxyde de silicium séparant un film mince de silicium monocristallin de la masse de substrat ;
- d'autres procédés qui utilisent le principe de l'amincissement d'une plaquette par abrasion mécanochimique ou chimique.

Ces divers procédés de réalisation de films minces semiconducteurs présentent des inconvénients liés aux techniques de fabrication.

Les méthodes d'hétéroépitaxie sont limitées par la nature du substrat : le paramètre de maille du substrat n'étant pas strictement exact à celui du semiconducteur, le film mince comporte beaucoup de défauts cristallins. En outre, ces substrats sont chers et fragiles et n'existent qu'en dimension limitée.

Le procédé SIMOX requiert une implantation ionique à très forte dose ce qui nécessite une machine d'implantation très lourde et complexe. Le débit de ces machines est faible et il est difficilement envisageable de l'augmenter dans des proportions notables.

Les procédés d'amincissement ne sont compétitifs du point de vue de l'homogénéité et de la qualité que s'ils utilisent le principe de la barrière d'arrêt à la gravure qui permet d'arrêter l'amincissement de la plaquette dès que l'épaisseur requise est atteinte et donc de garantir une homogénéité d'épaisseur. Malheureusement, la création de cette barrière d'arrêt rend le procédé complexe et peut limiter dans certains cas l'utilisation du film.

Pour remédier à ces inconvénients, il a été proposé, dans le document FR-A-2 681 472, un procédé de fabrication d'un film mince semiconducteur et sa solidarisation sur un support, consistant à soumettre une plaquette du matériau semiconducteur désiré et comportant une face plane aux étapes suivantes :
- une première étape d'implantation par bombardement de la face plane dudit matériau au moyen d'ions aptes à créer, dans le volume de la plaquette et à une profondeur voisine de la profondeur de pénétration desdits ions, une couche de microbulles gazeuses séparant la plaquette en une région inférieure constituant la masse du substrat et une région supérieure constituant le film mince, les ions étant choisis parmi les ions de gaz rares ou de gaz hydrogène et la température de la plaquette étant maintenue au-dessous de la température à laquelle le gaz engendré par les ions implantés peut s'échapper du semiconducteur par diffusion ;
- une deuxième étape de mise en contact intime de la face plane de la plaquette avec un support constitué au moins d'une couche de matériau rigide. Ce contact intime pouvant être réalisé par exemple à l'aide d'une substance adhésive, ou à l'aide d'une adhésion moléculaire par l'effet d'une préparation préalable des surfaces et éventuellement d'un traitement thermique ou/et électrostatique pour favoriser les liaisons interatomiques entre le support et la plaquette ;
- une troisième étape de traitement thermique de l'ensemble plaquette et support à une température supérieure à la température durant laquelle l'implantation a été effectuée et suffisante pour créer par effet de réarrangement cristallin dans la plaquette et de pression des microbulles une séparation entre le film mince et la masse du substrat.

Dans ce document, on propose l'explication suivante aux différents phénomènes constatés par l'expérience. Tout d'abord, la première étape d'implantation ionique est menée en présentant à un faisceau d'ions une face plane d'une plaquette de matériau semiconducteur, le plan de cette face plane étant soit sensiblement parallèle à un plan cristallographique principal dans le cas où le matériau semiconducteur est parfaitement monocristallin, soit plus ou moins incliné par rapport à un plan cristallographique principal de mêmes indices pour tous les grains dans le cas où le matériau est polycristallin.

Cette implantation est apte à créer une couche de microbulles gazeuses qui aboutira en fin de traitement thermique à une zone de fracture. Cette couche de microbulles créée ainsi dans le volume de la plaquette, à une profondeur voisine de la profondeur moyenne de pénétration des ions, délimite dans le volume de la plaquette deux régions séparées par cette couche : une région destinée à constituer le film mince et une région formant le reste du substrat. Par l'expression "microbulle gazeuse" on entend toute cavité ou microcavité générée par l'implantation d'ions de gaz hydrogène ou de gaz rares dans le matériau. Les cavités peuvent se présenter sous forme très aplatie, c'est-à-dire de faible hauteur, par exemple de l'ordre de quelques distances inter-atomiques, aussi bien que sous forme sensiblement hémisphérique ou sous tout autre forme différente des deux formes précédentes. Ces cavités peuvent ou non contenir une phase gazeuse. Au cours de la troisième étape, le traitement thermique est réalisé à une température suffisante pour créer, par effet de réarrangement cristallin dans le matériau semiconducteur tel que par exemple par effet de croissance des microcavités et/ou par effet de pression des microbulles, la zone de fracture et la séparation entre les deux régions.

Suivant les conditions d'implantation, après implantation d'un gaz comme par exemple l'hydrogène, des cavités ou microbulles sont observables ou non en microscopie électronique à transmission. Dans le cas du silicium, on peut avoir des microcavités dont la taille peut varier de quelques nm à quelques centaines de nm. Ainsi, en particulier lorsque la température d'implantation est faible, ces cavités ne sont observables qu'au cours de l'étape de traitement thermique, étape au cours de laquelle on réalise alors une nucléation de ces cavités pour permettre d'aboutir en fin de traitement thermique à la fracture entre le film mince et le reste du substrat.

En outre, il semble que ce procédé peut s'appliquer à tous les types de matériaux solides, cristallins ou non. Il est possible d'appliquer ce procédé à des matériaux diélectriques, conducteurs, semi-isolants, ainsi qu'à des matériaux semiconducteurs amorphes.

La couche contenant des microbulles ou des microcavités est une couche continue en ce sens que les microbulles ou les microcavités sont présentes selon une densité suffisante pour que l'interaction entre les microbulles ou les microcavités se produise sur toute la plaquette et conduise à une fracture. Si l'implantation ionique est masquée localement, de façon volontaire ou de façon involontaire, par exemple par une particule de l'ordre du µm ou inférieure à 1 µm, la discontinuité de faible dimension en résultant n'empêche pas la fracture de se propager.

L'objet de tous ces procédés est d'obtenir un film mince semiconducteur sur un support, pour y élaborer ensuite des composants électroniques par des procédés classiques. Le procédé décrit dans le document FR-A-2 681 472 permet d'apporter une solution aux problèmes inhérents aux techniques antérieures. Cependant, pour obtenir un dispositif constitué d'un support revêtu d'un film mince semiconducteur dans lequel on a élaboré des composants électroniques, il implique une étape relevant du domaine de la microélectronique (étape d'implantation ionique), suivie d'étapes relevant du domaine de la mécanique (étape de mise en contact) et du domaine thermique (étape de traitement thermique), pour revenir à des étapes relevant du domaine de la microélectronique (élaboration des composants électroniques).

Il revient aux inventeurs de la présente invention d'avoir pensé à regrouper de manière consécutive certaines étapes relevant du domaine de la microélectronique, c'est-à-dire jusqu'à l'élaboration de tout ou partie des composants électroniques, ceci afin d'optimiser la fabrication ou de permettre l'utilisation de substrat comportant à l'origine des éléments, par exemple électroniques, et d'y définir ensuite un film mince. Pour parvenir à ce résultat, il a fallu résoudre le problème suivant constitué par le fait que l'élaboration d'éléments électroniques dans une couche semiconductrice provoque la constitution d'un milieu hétérogène, c'est-à-dire constitué de divers matériaux (semiconducteur, métaux pour les contacts électriques, isolants, etc.). Les ions implantés sont donc distribués à différentes profondeurs par rapport à la surface de réception des ions. A titre d'exemple, une implantation d'ions hydrogène d'énergie 400 keV dans le silicium conduit à la formation de microbulles localisées à une distance d'environ 4 µm de la surface offerte aux ions. Cette distance est de 3 µm pour une même implantation dans du silicium ayant une couche de tungstène de 600 nm d'épaisseur en surface (voir "The Stopping and Range of Ions in Solids" par J. Ziegler et al., Pergamon, New York, 1985). En conséquence, dans le cas où la surface traitée présente différents matériaux sur le trajet des ions, les microbulles (ou microcavités) ne sont pas toutes localisées dans une couche suffisamment étroite pour que l'interaction entre les bulles se produise sur toute la surface de la plaquette. La séparation du film mince du reste de la plaquette semiconductrice ne peut pas alors se produire de manière satisfaisante.

Un autre problème était constitué par le fait qu'une implantation d'ions au travers des couches électriquement actives contenant différents dopants et des isolants peut créer des défauts qui modifient les caractéristiques des composants ou les rendent inutilisables.

La présente invention permet d'apporter une solution à ces problèmes. On propose de réaliser l'implantation ionique en fonction de la nature des matériaux traversés par les ions de manière à obtenir une zone continue de microbulles permettant un clivage (ou fracture) satisfaisant entre le film mince et le reste de la plaquette semiconductrice. De façon avantageuse, on peut procéder en plusieurs implantations à différentes énergies. Le nombre d'implantations est alors fixé par le nombre de matériaux ayant des comportements différents vis-à-vis de l'implantation. Des implantations à différentes énergies permettent de créer une zone continue de microbulles située à une profondeur constante par rapport à la surface recevant les ions. A titre d'exemple, pour une implantation d'ions hydrogène dans du silicium, il faut que les microbulles soient localisées dans une zone dont l'épaisseur est inférieure à 200 nm pour que l'interaction entre les bulles puisse avoir lieu au cours du traitement thermique subséquent et conduise à la séparation des régions situées de part et d'autre de la zone contenant les microbulles, de façon continue sur toute la plaquette.

L'invention apporte aussi une solution au second problème éventuel résultant de la création de défauts induits par le passage des ions au travers des couches électriquement actives.

On sait que de tels défauts peuvent être corrigés par l'application d'un traitement thermique. C'est l'objet des articles "Physical and electrical properties of laser-annealed ion-implanted silicon" de A. Gat et al. paru dans la revue Appl. Phys. Lett. 32 (5), 1er Mars 1978, et "Pulsed-electron-beam annealing of ion-implantation damage" de A.C. Greenwald et al. paru dans la revue J. Appl. Phys. 50(2), Février 1979. Si on veut corriger les défauts induits dans les composants électroniques lors de l'étape d'implantation par un traitement thermique particulier avant l'étape de séparation, ce traitement thermique ne doit pas alors affecter la zone contenant les microbulles car il provoquerait la séparation des deux régions situées de part et d'autre de cette zone. Par contre, ce recuit doit chauffer toute la zone contenant les composants électroniques pour guérir les défauts induits. Selon l'invention, on propose donc d'effectuer un recuit transitoire, juste après l'étape d'implantation ionique, pour chauffer les régions défectueuses pour supprimer les défauts mais sans chauffer la zone contenant les microcavités.

On peut également, pour corriger les défauts induits par l'étape d'implantation, effectuer un traitement thermique global. Si ce traitement est réalisé avant l'étape de séparation, il doit être effectué à une température suffisante mais inférieure à celle nécessaire pour obtenir ladite séparation, sur l'ensemble de la structure avec éventuellement le support de film mince. Ce traitement thermique peut également être réalisé après l'étape de séparation, sur l'ensemble du film mince avec éventuellement son support et dans ces conditions la température mise en oeuvre n'est pas critique. Enfin, ce traitement thermique peut être confondu avec le traitement thermique nécessaire à la séparation du film mince du reste du substrat, en adaptant les conditions de température et de durée. Le choix entre les différents traitements thermiques possibles dépend des matériaux utilisés et des composants.

L'invention a donc pour objet un procédé d'obtention d'un film mince à partir d'un substrat en matériau semiconducteur, le film mince comprenant au moins un élément en un matériau différent dudit matériau semiconducteur, réalisé sur une face du substrat et conférant au film mince une structure hétérogène, caractérisé en ce qu'il comporte les étapes suivantes :
- implantation par bombardement de la face dudit substrat comportant ledit élément au moyen d'ions aptes à créer dans le volume du substrat des microbulles gazeuses, l'implantation étant réalisée en tenant compte de l'élément réalisé de manière à obtenir une zone continue de microbulles gazeuses délimitant une région de faible épaisseur, du côté de ladite face du substrat et contenant ledit élément, et une région d'épaisseur sensiblement plus importante formée du reste du substrat, les ions étant choisis parmi les ions de gaz rares ou de gaz hydrogène et la température du substrat étant maintenue au-dessous de la température à laquelle le gaz engendré par les ions implantés peut s'échapper du semiconducteur par diffusion,
- ensuite, traitement thermique du substrat à une température suffisante pour créer, par effet de réarrangement cristallin dans le substrat et de pression des microbulles, une séparation des deux régions situées de part et d'autre de la zone de microbulles gazeuses, la région de faible épaisseur constituant le film mince.

On entend par substrat en matériau semiconducteur un substrat dont au moins la partie supérieure qui va permettre de réaliser le film mince est semiconductrice. L'implantation ionique peut être réalisée en une ou plusieurs implantations successives suivant le nombre de matériaux présents dans le substrat comportant un pouvoir d'arrêt différent vis-à-vis des ions implantés. Ainsi pour un élément ayant le même pouvoir d'arrêt que le substrat, une implantation en une étape suffit, sinon on opère par implantations successives, l'énergie des ions pour chaque implantation étant choisie pour obtenir ladite zone continue de microbulles.

Le procédé peut comporter en outre une étape de traitement thermique destinée à corriger les défauts induits dans ledit élément lors de l'étape d'implantation.

Dans ce cas, et si l'étape de traitement thermique de correction des défauts induits dans ledit élément est effectuée avant l'étape de traitement thermique destinée à séparer lesdites régions du substrat, ce traitement thermique de correction peut être localisé à la zone du substrat contenant ledit élément. Ce traitement thermique de correction peut être réalisé au moyen d'un faisceau laser.

Ledit élément peut être tout ou partie d'un composant électronique ou un conducteur électrique.

Selon une variante de réalisation, avant l'étape de traitement thermique destinée à séparer lesdites régions du substrat, il est prévu une étape de mise en contact intime de ladite face du substrat comprenant ledit élément avec un support. Cette mise en contact intime peut être réalisée par tout moyen connu, par exemple par adhésion moléculaire ou par l'utilisation d'une substance adhésive. Ce support peut également comporter au moins tout ou partie d'un composant électronique et/ou au moins un conducteur électrique.

L'invention sera mieux comprise et d'autres détails et particularités apparaîtront à la lecture de la description qui va suivre, donnée à titre d'exemple non limitatif, accompagnée des dessins annexés parmi lesquels :
- la figure 1 est une vue en coupe d'un substrat semiconducteur sur une face duquel on a réalisé un composant électronique,
- la figure 2 illustre le substrat de la figure 1 au cours d'une première étape d'implantation ionique,
- la figure 3 illustre le même substrat au cours d'une deuxième étape d'implantation ionique,
- la figure 4 représente la mise en contact du substrat, ayant subi les deux étapes d'implantation ionique, avec un raidisseur,
- la figure 5 montre le film mince solidaire du raidisseur, tel qu'il résulte de l'étape de traitement thermique destinée à séparer le film mince du reste du substrat.

Dans l'exemple d'application qui va suivre, le film mince sera équipé d'un composant électronique constitué de trois types de matériaux : du silicium monocristallin pour les zones actives, de l'oxyde de silicium en tant que diélectrique et du tungstène pour assurer les contacts. L'invention n'est cependant pas limitée au cas des composants électroniques. Elle s'applique également à la fabrication de films minces comportant d'autres éléments qui sont, par nature, susceptibles de modifier la profondeur d'implantation des ions dans le matériau semiconducteur, par exemple des bandes métalliques servant à la connexion électrique entre circuits ou composants.

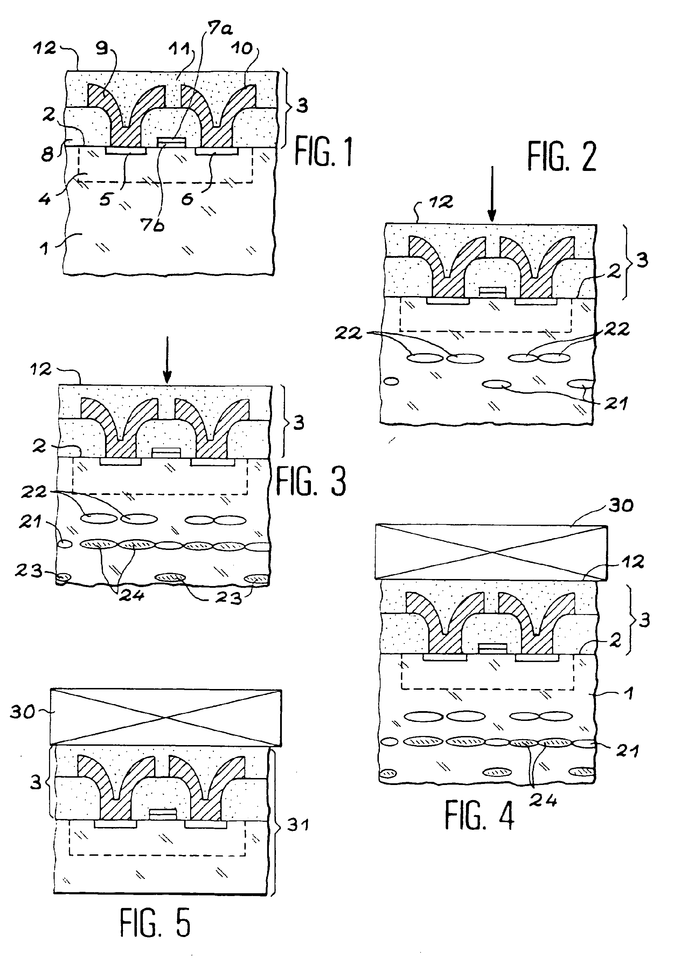

La figure 1 montre un substrat semiconducteur 1 en silicium monocristallin sur une face 2 duquel on a réalisé un composant électronique (un transistor 3). Le transistor 3 a été réalisé selon une technique connue de l'homme du métier. On trouve un caisson 4 dopé de manière appropriée dans lequel on a créé par dopage une source 5 et un drain 6. Une grille 7a en silicium polycristallin et un oxyde de grille 7b ont été formés sur la face 2 du substrat, entre la source 5 et le drain 6. Une couche 8 d'oxyde de silicium a ensuite été déposée et des contacts en tungstène 9 et 10, respectivement de source et de drain, ont été créés au travers de la couche d'oxyde 8. Une couche de passivation 11, en oxyde de silicium, a finalement été déposée au dessus du composant 3 ainsi réalisé.

Suivant l'état de surface de la plaquette semiconductrice obtenue, il peut être nécessaire d'effectuer un polissage mécanochimique de la face supérieure 12 afin d'obtenir une rugosité compatible avec une mise en contact de cette face avec une face d'un raidisseur lors d'une étape postérieure. En effet, sur des composants électroniques la topologie de surface peut être de l'ordre de plusieurs centaines de nm alors que la rugosité de surface pour assurer un collage, par exemple par adhésion moléculaire, sur le raidisseur doit être inférieure à environ 0,5 nm en rugosité rms. A cet effet, on pourra se reporter à la référence suivante : T. ABE et al., Electrochemical Society Conference, Wafer Bonding Symposium, 1990, 61.

On procède ensuite à une première étape d'implantation ionique par bombardement de la plaquette par un faisceau d'ions dirigé vers la face 12, c'est-à-dire vers la face 2 du substrat 1 comme schématisé par la flèche. Les ions susceptibles d'être implantés ont été définis dans le document FR-A-2 681 472.

La figure 2 illustre cette première étape d'implantation ionique. En utilisant des ions hydrogène de 400 keV d'énergie, on obtient deux profondeurs différentes d'implantation. L'hydrogène implanté qui ne traverse que du silicium ou de l'oxyde de silicium forme des microcavités 21 à 4 µm de profondeur par rapport à la face 12 de la plaquette. Par contre, l'hydrogène implanté de même énergie qui traverse des zones contenant une couche de tungstène (d'épaisseur moyenne 0,6 µm) forme des microcavités à 3 µm de profondeur par rapport à la face 12.

Il est alors nécessaire de procéder à une deuxième étape d'implantation ionique comme cela est illustré par la figure 3. Une implantation d'ions hydrogène de 470 keV d'énergie permet d'obtenir un second profil de microcavités 23, 24 à une profondeur supérieure à la profondeur du premier profil de microcavités 21, 22. Les énergies d'implantation ont été choisies de façon à obtenir l'alignement des microcavités 21 et 24. On obtient ainsi une zone continue de microcavités ou microbulles gazeuses qui permet de délimiter une région supérieure qui constituera le film mince et une région inférieure qui formera le reste du substrat.

Le nombre d'étapes d'implantation est fonction du nombre de matériaux se comportant différemment vis-à-vis de l'implantation. On entend par comportement différent le fait que les ions ne possèdent pas la même profondeur moyenne de pénétration dans ces matériaux.

Une fois terminée la dernière étape d'implantation, on procède par exemple à un recuit transitoire qui permet de chauffer uniquement la zone qui contient le composant électronique. Cette étape n'est nécessaire que dans le cas où le composant est perturbé par l'implantation des ions. A titre d'exemple, ce recuit peut être effectué au moyen d'un faisceau laser dirigé vers la face 12, de longueur d'onde inférieure à 0,4 µm, apportant une énergie de 0,2 à 1 J/cm² pendant une durée de 150 ns. Dans ces conditions, une température de l'ordre de 800 à 900°C peut être atteinte durant quelques microsecondes. Ces températures sont compatibles avec la guérison des défauts. Ce recuit de type laser peut être réalisé soit en une seule fois sur toute la surface de la plaque, soit en plusieurs traitements zone par zone.

La figure 4 illustre l'étape de mise en contact intime de la plaquette avec un raidisseur 30. Ce raidisseur peut être soit un substrat massif (en verre par exemple), soit un substrat contenant des composants électroniques et/ou des conducteurs électriques. La présence de ce raidisseur permettra d'obtenir le mécanisme de séparation entre la région supérieure du substrat 1 et la région inférieure ainsi que l'enseigne le document FR-A-2 681 472.

Cependant, dans le cas où l'épaisseur du film mince de matériau semiconducteur est suffisamment importante pour présenter une rigidité satisfaisante, la présence d'un raidisseur n'est pas nécessaire et le polissage de la face 12 de la plaquette n'est pas non plus nécessaire.

On met ensuite en oeuvre un traitement thermique isotherme qui chauffe de façon homogène l'ensemble formé de la plaquette et du raidisseur à une température supérieure à la température à laquelle est réalisé le bombardement ionique et suffisante pour créer, par effet de réarrangement cristallin dans le substrat et de pression dans les microbulles, une séparation du substrat en deux régions situées de part et d'autre de la zone continue de microcavités 21, 24. On obtient ainsi, comme le montre la figure 5, un film mince 31 comprenant un composant électronique 3 supporté par un raidisseur 30.

Bien que l'exemple décrit ci-dessus ne mentionne qu'un seul composant électronique, l'invention s'applique également à la réalisation d'un film mince équipé d'un ou de plusieurs composants tout ou partie formés.

## Revendications

1. Procédé d'obtention d'un film mince (31) partir d'un substrat (1) en matériau semiconducteur, le film mince comprenant au moins un élément (3) en un matériau différent dudit matériau semiconducteur, réalisé sur une face du substrat et conférant au film mince une structure hétérogène, lequel procédé comporte les étapes suivantes :
- implantation par bombardement de la face (2) dudit substrat (1) comportant ledit élément au moyen d'ions aptes à créer dans le volume du substrat (1) des microbulles gazeuses (21 à 24), l'implantation étant réalisée en tenant compte de l'élément réalisé de manière à obtenir une zone continue de microbulles gazeuses (21, 24) délimitant une région de faible épaisseur, du côté de ladite face (2) du substrat (1) et contenant ledit élément (3), et une région d'épaisseur sensiblement plus importante formée du reste du substrat, les ions étant choisis parmi les ions de gaz rares ou de gaz hydrogène et la température du substrat (1) étant maintenue au-dessous de la température à laquelle le gaz engendré par les ions implantés peut s'échapper du semiconducteur par diffusion,
- ensuite, traitement thermique du substrat (1) à une température suffisante pour créer, par effet de réarrangement cristallin dans le substrat et de pression des microbulles, une séparation des deux régions situées de part et d'autre de la zone de microbulles gazeuses (21, 24), la région de faible épaisseur constituant le film mince (31).

2. Procédé selon la revendication 1, **caractérisé en ce que**, lors de l'étape d'implantation ionique, on opère par implantations successives, l'énergie des ions pour chaque implantation étant choisie pour obtenir ladite zone continue de microbulles (21, 24).

3. Procédé selon l'une des revendications 1 ou 2, **caractérisé en ce qu'**il comporte en outre une étape de traitement thermique destinée à corriger les défauts induits dans ledit élément (3) lors de l'étape d'implantation.

4. Procédé selon la revendication 3, **caractérisé en ce que**, l'étape de traitement thermique de correction des défauts induits dans ledit élément (3) étant effectuée avant l'étape de traitement thermique destinée à séparer lesdites régions du substrat, ce traitement thermique de correction est localisé à la zone du substrat contenant ledit élément (3).

5. Procédé selon la revendication 4, **caractérisé en ce que** le traitement thermique de correction est réalisé au moyen d'un faisceau laser.

6. Procédé selon la revendication 3, **caractérisé en ce que**, l'étape de traitement thermique de correction des défauts induits dans ledit élément (3) étant effectuée avant l'étape de traitement thermique destinée à séparer lesdites régions du substrat, ce traitement thermique de correction consiste à porter le substrat à une température suffisante pour obtenir la guérison des défauts mais inférieure à la température requise pour obtenir la séparation desdites deux régions.

7. Procédé selon la revendication 3, **caractérisé en ce que** l'étape de traitement thermique de correction des défauts induits dans ledit élément (3) est effectuée après l'étape de traitement thermique destinée à séparer lesdites régions du substrat.

8. Procédé selon la revendication 3, **caractérisé en ce que** l'étape de traitement thermique de correction des défauts induits dans ledit élément et l'étape de traitement thermique destinée à séparer lesdites régions du substrat sont confondues en une même opération de traitement thermique.

9. Procédé selon l'une quelconque des revendications 1 à 8, **caractérisé en ce que** ledit élément (3) est tout ou partie d'un composant électronique ou un conducteur électrique.

10. Procédé selon l'une quelconque des revendications 1 à 9, **caractérisé en ce que**, avant l'étape de traitement thermique destinée à séparer lesdites régions du substrat, il est prévu une étape de mise en contact intime de ladite face du substrat comprenant ledit élément avec un support (30).

11. Procédé selon la revendication 10, **caractérisé en ce que** ledit support (30) comporte au moins tout ou partie d'un composant électronique et/ou au moins un conducteur électrique.

## Claims

1. Method of obtaining a thin film (31) from a substrate (1) of semiconductor material, the thin film including at least one element (3) of a different material from that of said semiconductor material, produced on one face of the substrate and conferring on the thin film a heterogeneous structure, said method including the following steps:
- implantation by bombardment of the face (2) of said substrate (1) including said element by ions capable of creating within the volume of the substrate (1) gaseous microbubbles (21 to 24), the implantation being carried out having regard to the element produced in such a way that a continuous zone of microbubbles (21 to 24) is obtained demarcating a region of small thickness, on the side of said face (2) of the substrate (1) and containing said element (3) and a region of appreciably greater thickness formed by the rest of the substrate, the ions being chosen from among the ions of rare gases or of hydrogen gas and the temperature of the substrate (1) being kept below the temperature at which the gas generated by the implanted ions is able to escape from the semiconductor by diffusion,
- then, thermal treatment of the substrate (1) at a temperature that is sufficient to create, by a crystalline rearrangement effect in the substrate and the effect of microbubble pressure, a separation of the two regions situated on each side of the zone of gaseous microbubbles (21 to 24), the region of small thickness constituting the thin film (31).

2. Method according to claim 1, **characterized in that** during the ion implantation step, successive implantations are operated, the energy of the ions for each implantation being chosen in order to obtain said continuous zone of microbubbles (21 to 24).

3. Method according to claim 1 or 2, **characterized in that** it also comprises a thermal treatment step intended to correct the defects induced in said element (3) during the implantation step.

4. Method according to claim 3, **characterized in that** the thermal treatment step for correcting the defects induced in said element (3) being carried out before the thermal treatment step intended to separate said regions of the substrate, this thermal correction treatment is localized to the area of substrate containing said element (3).

5. Method according to claim 4, **characterized in that** the thermal correction treatment is carried out using a laser beam.

6. Method according to claim 3, **characterized in that** the thermal correction treatment of defects induced in said element (3) being carried out before the thermal treatment step intended to separate said regions of the substrate, this thermal correction treatment consists of bringing the substrate to a temperature sufficient to obtain the remedying of the defects but is less than the temperature required to obtain the separation of said two regions.

7. Method according to claim 3, **characterized in that** the thermal correction treatment of defects induced in said element (3) is carried out after the thermal treatment step intended to separate the said regions of the substrate.

8. Method according to claim 3, **characterized in that** the thermal correction treatment of defects induced in said element and the thermal treatment step intended to separate the said regions of the substrate are combined into one and the same thermal treatment operation.

9. Method according to any one of the claims 1 to 8, **characterized in that** said element (3) is all or part of an electronic component or an electrical conductor.

10. Method according to any one of the claims 1 to 9, **characterized in that** before the thermal treatment step intended to separate the said regions of the substrate, a step is provided in which said face of the substrate including said element is brought into intimate contact with a support (30).

11. Method according to claim 10, **characterized in that** said support (30) includes all or a part of at least one electronic component and/or at least one electrical conductor.

## Patentansprüche

1. Verfahren zum Erhalten eines dünnen Films (31) aus einem Substrat (1) aus einem Halbleitermaterial, wobei der dünne Film wenigstens ein Element (3) aus einem von dem Halbleitermaterial verschiedenen Material auf einer Fläche des Substrats umfaßt, das dem dünnen Film eine heterogene Struktur verleiht, und das Verfahren die folgenden Schritte umfaßt:
- Implantation durch Bombardierung der Fläche (2) des Substrats (1), das das Element umfaßt, durch zum Erzeugen gasförmiger Mikroblasen (21 bis 24) innerhalb des Volumens des Substrats (1) befähigter Ionen, wobei die Implantation unter Berücksichtigung des Elements derart durchgeführt wird, daß eine kontinuierliche Zone mit gasförmigen Mikroblasen (21, 24) gebildet wird, die einen Bereich geringer Dicke auf der Seite der Fläche (2) des das Element (3) enthaltenden Substrats (1) und einen durch den Rest des Substrats gebildeten Bereich wesentlich größerer Dicke abgrenzt, wobei die Ionen aus den Ionen von Edelgasen oder von Wasserstoffgas ausgewählt sind und die Temperatur des Substrats (1) unter der Temperatur gehalten wird, bei der das durch die implantierten Ionen erzeugte Gas durch Diffusion aus dem Halbleiter zu entweichen vermag, und
- anschließend Wärmebehandlung des Substrats (1) bei einer Temperatur, die zum Erzeugen einer Trennung der zwei Bereiche auf beiden Seiten der Zone mit den gasförmigen Mikroblasen (21, 24) durch die Auswirkung einer kristallinen Umlagerung in dem Substrat und des Drucks der Mikrokugeln ausreichend ist, wobei der Bereich der geringen Dicke den dünnen Film (31) darstellt.

2. Verfahren gemäß Anspruch 1, **dadurch gekennzeichnet, daß** der lonenimplantationsschritt weitere aufeinanderfolgende Implantationen umfaßt, wobei die Energie der Ionen für jede Implantation zum Erhalten der kontinuierlichen Mikroblasenzone (21, 24) ausgewählt ist.

3. Verfahren gemäß einem der Ansprüche 1 oder 2, **dadurch gekennzeichnet, daß** es weiter einen Wärmebehandlungsschritt zum Beheben der in dem Element (3) während des Implantationsschritts erzeugten Defekte umfaßt.

4. Verfahren gemäß Anspruch 3, **dadurch gekennzeichnet, daß** der Wärmebehandlungsschritt zum Beheben der in dem Element (3) erzeugten Defekte vor dem Wärmebehandlungsschritt zum Trennen der Bereiche des Substrats durchgeführt wird und diese Wärmekorrekturbehandlung auf der das Element (3) enthaltenden Substratfläche lokalisiert ist.

5. Verfahren gemäß Anspruch 4, **dadurch gekennzeichnet, daß** die Wärmekorrekturbehandlung mittels eines Laserstrahls durchgeführt wird.

6. Verfahren gemäß Anspruch 3, **dadurch gekennzeichnet, daß** der Wärmehandlungsschritt zum Beheben in dem Element (3) erzeugter Defekte vor dem Wärmebehandlungsschritt zum Trennen der Bereiche des Substrats durchgeführt wird und diese Wärmekorrekturbehandlung aus dem Bringen des Substrats auf eine zum Beheben der Defekte ausreichende Temperatur besteht, wobei die Temperatur kleiner als die zum Erhalten der Trennung der beiden Bereiche erforderliche Temperatur ist.

7. Verfahren gemäß Anspruch 3, **dadurch gekennzeichnet, daß** der Wärmebehandlungsschritt zum Beheben in dem Element (3) erzeugter Defekte nach dem Wärmebehandlungsschritt zum Trennen der Bereiche des Substrats durchgeführt wird.

8. Verfahren gemäß Anspruch 3, **dadurch gekennzeichnet, daß** der Wärmebehandlungsschritt zum Beheben in dem Element erzeugter Defekte und der Wärmebehandlungsschritt zum Trennen der Bereiche des Substrats zu einem einzigen Wärmebehandlungsarbeitsschritt zusammengeführt werden.

9. Verfahren gemäß einem der Ansprüche 1 bis 8, **dadurch gekennzeichnet, daß** das Element (3) ein ganzes elektronisches Bauteil oder ein elektrischer Leiter oder ein Teil davon ist.

10. Verfahren gemäß einem der Ansprüche 1 bis 9, **dadurch gekennzeichnet, daß** vor dem Wärmebehandlungsschritt zum Trennen der Bereiche des Substrats ein Schritt des engen In-Kontakt-Bringens der das Element enthaltenden Substratfläche mit einem Träger (30) vorgesehen ist.

11. Verfahren gemäß Anspruch 10, **dadurch gekennzeichnet, daß** der Träger (30) wenigstens ein ganzes elektronisches Bauteil und/oder wenigstens einen elektrischer Leiter oder ein Teil davon umfaßt.
